# EUROPEAN PATENT APPLICATION

(11) **EP 2 754 645 A1**
(43) Date of publication of application: **16.07.2014**
(21) Application number: 12829869.2
(22) Date of filing: 05.09.2012
(51) Int. Cl.: C03C 17/245, B32B 9/00, B32B 17/06, C03C 17/34, C23C 16/40, H01L 31/04

(54) **GLASS SUBSTRATE HAVING ALKALI BARRIER LAYER ATTACHED THERETO, AND GLASS SUBSTRATE HAVING TRANSPARENT CONDUCTIVE OXIDE FILM ATTACHED THERETO**

(30) Priority: 05.09.2011 JP 2011192511
(71) Applicant: Asahi Glass Company, Limited, Tokyo 100-8405 (JP)
(72) Inventor: HAYASHI, Hideaki, Tokyo 100-8405 (JP); MINOWA, Akihisa, Tokyo 100-8405 (JP); SEKI, Atsushi, Tokyo 100-8405 (JP); HIGASHI, Seiji, Tokyo 100-8405 (JP); HIROMATSU, Kuniaki, Tokyo 100-8405 (JP); OKAHATA, Naoki, Tokyo 100-8405 (JP)
(74) Representative: Müller-Boré & Partner Patentanwälte PartG mbB
(86) International application number: PCT/JP2012/072629
(87) International publication number: WO 2013/035746

(57) **Abstract**

To provide a glass substrate with an alkali barrier layer which is excellent in alkali barrier properties.

A glass substrate with an alkali barrier layer, comprising a glass substrate and an alkali barrier layer formed thereon, wherein the alkali barrier layer is composed of a mixed oxide of silicon (Si) and tin (Sn).

## Description

### TECHNICAL FIELD

The present invention relates to a glass substrate with an alkali barrier layer, and a glass substrate with a transparent conductive oxide film, wherein the glass substrate with an alkali barrier layer is used.

### BACKGROUND ART

As a glass substrate to be used for preparation of a liquid crystal display or a photoelectric conversion element such as a solar cell, alkali glass containing an alkali metal oxide, such as soda lime silicate glass, is preferred, since its production costs are low.

However, in the case of using alkali glass for such an application, in order to minimize diffusion of an alkali component to a transparent conductive oxide film formed on the substrate, it is necessary to form an alkali barrier layer such as a silicon oxide film, an aluminum oxide film, a zirconium oxide film or the like on the glass substrate and to form the transparent conductive oxide film on the alkali barrier layer.

As an alkali barrier layer to be formed on a glass substrate for such a purpose, a SiO₂ film, a mixed oxide film of SiO₂ and SnO₂, or a multi-layer film having a SiO₂ layer and a SnO₂ layer sequentially stacked, may, for example, be mentioned (Patent Document 1).

Further, Patent Document 2 discloses that when a SiO₂/SnO₂ mixed layer having the mixing ratio changed in its thickness direction, is provided between a SiO₂ layer formed as an alkali barrier layer on a glass substrate and a SnO₂ layer formed as a transparent electrode thereon, the bonding strength with the transparent electrode layer is thereby enhanced, whereby it is possible to obtain a stabilized transparent electrode, but no mention is made with respect to the alkali barrier properties of the SiO₂/SnO₂ mixed layer.

Further, in Patent Document 2, the SiO₂/SnO₂ mixed layer is provided so that the SnO₂ content is continuously or gradually increased from the SiO₂ layer side towards the transparent electrode side.

### PRIOR ART DOCUMENTS

### PATENT DOCUMENTS

Patent Document 1: JP-A-2009-140930
Patent Document 2: Japanese Patent No. 3,291,401

### DISCLOSURE OF INVENTION

### TECHNICAL PROBLEM

Accordingly, by using a mixed oxide film of SiO₂ and SnO₂ as an alkali barrier layer to be formed on a glass substrate and by changing the mixing ratio in the mixed oxide film in the film thickness direction, it is expected that an alkali barrier layer excellent in the alkali barrier properties can be obtained.

It is an object of the present invention to provide a glass substrate with an alkali barrier layer excellent in the alkali barrier properties.

Further, it is another object of the present invention to provide a glass substrate with a transparent conductive oxide film, having a transparent conductive oxide film formed on the alkali barrier layer of such a glass substrate with an alkali barrier layer.

### SOLUTION TO PROBLEM

In order to accomplish the above objects, the present inventors have conducted an extensive study and as a result have found that when the mixing ratio in the mixed oxide film of SiO₂ and SnO₂ is adjusted to satisfy a specific relation in the film thickness direction, it is possible to improve the alkali barrier properties of the mixed oxide film.

The present invention has been made based on such a discovery and provides a glass substrate with an alkali barrier layer, comprising a glass substrate and an alkali barrier layer formed thereon, wherein
the alkali barrier layer is composed of a mixed oxide of silicon (Si) and tin (Sn), and when the thickness of the alkali barrier layer is represented by L (nm), the ratio between silicon (Si) and tin (Sn) in the mixed oxide is changed in the thickness direction so that the minimum value in the molar ratio [Sn/(Si+Sn)] of tin (Sn) to the total of silicon (Si) and tin (Sn) in the mixed oxide is located at a position which satisfies from 0.2 L to 0.8 L from the interface on the glass substrate side among interfaces of the alkali barrier layer in the thickness direction of the alkali barrier layer, and
the minimum value is at most 0.5 time the maximum value in the molar ratio.

In the glass substrate with an alkali barrier layer of the present invention, the minimum value is preferably at most 0.1.

In the glass substrate with an alkali barrier layer of the present invention, the maximum value is preferably at least 0.05 and at most 0.7.

In the glass substrate with an alkali barrier layer of the present invention, the thickness of the alkali barrier layer is preferably from 2 to 50 nm.

In the glass substrate with an alkali barrier layer of the present invention, the glass substrate is preferably made of alkali glass containing an alkali metal oxide.

In the glass substrate with an alkali barrier layer of the present invention, a TiO₂ layer, or a multi-layer film having a TiO₂ layer and a SiO₂ layer stacked, may be formed between the glass substrate and the alkali barrier layer.

In the glass substrate with an alkali barrier layer of the present invention, a SiO₂ layer may be formed between the glass substrate and the alkali barrier layer, or on the surface of the alkali barrier layer.

In the glass substrate with an alkali barrier layer of the present invention, fine concave and convex portions may be formed on the surface of the glass substrate on which the alkali barrier layer is formed.

Further, the present invention provides a glass substrate with a transparent conductive oxide film, comprising the glass substrate with an alkali barrier layer of the present invention, and a fluorine-doped tin oxide film formed as a transparent conductive oxide film on the alkali barrier layer.

Further, the present invention provides a glass substrate with a transparent conductive oxide film, comprising the glass substrate with an alkali barrier layer of the present invention, and a tin oxide film and a fluorine-doped tin oxide film stacked as transparent conductive oxide films on the alkali barrier layer.

The above " to " representing a numerical range is used to be meant for including the numerical values given before and after thereof as the lower limit value and the upper limit value, and unless otherwise specified, hereinafter in this specification, " to " representing a numerical range will be used to have the same meaning.

### ADVANTAGEOUS EFFECT OF INVENTION

In the glass substrate with an alkali barrier layer of the present invention, the minimum value in the molar ratio [Sn/(Si+Sn)] in the mixed oxide constituting the alkali barrier layer is present in the vicinity of the center in the thickness direction of the alkali barrier layer, and the minimum value is at most 0.5 time the maximum value in the molar ratio of Sn/(Si+Sn), whereby the alkali barrier properties are improved.

### BRIEF DESCRIPTION OF DRAWINGS

Fig. 1 is a schematic view illustrating one embodiment of a conveyor-type atmospheric pressure CVD apparatus to be used for forming the alkali barrier layer of the present invention.
Fig. 2 is a graph showing a composition profile in the film thickness direction in Example 1.
Fig. 3 is a graph showing a composition profile in the film thickness direction in Example 2.

### DESCRIPTION OF EMBODIMENTS

Now, the glass substrate with an alkali barrier layer of the present invention will be described.

The glass substrate with an alkali barrier layer of the present invention is one having an alkali barrier layer formed on a glass substrate.

The constructions of individual components of the glass substrate with an alkali barrier layer of the present invention will be described as follows.

### <Glass substrate>

As the glass substrate, soda lime silicate glass, aluminosilicate glass, borate glass, lithium aluminosilicate glass, quartz glass, borosilicate glass, alkali-free glass or other various glass containing an alkali metal oxide, may, for example, be used.

However, the main purpose of forming an alkali barrier layer on the glass substrate is to minimize diffusion of an alkali component to a transparent conductive oxide film or an antireflection film formed on the glass substrate, and therefore, the glass substrate is preferably alkali glass containing an alkali metal oxide, such as soda lime silicate glass, or aluminosilicate glass or lithium aluminosilicate glass containing an alkali metal oxide. For example, as soda lime silicate glass, a glass composition comprising, by mass%, 72.9% of SiO₂, 1.9% of Al₂O₃, 3.7% of MgO, 3.7% of CaO, 13.1 % of Na₂O and 0.3% of K₂O may be mentioned as a typical example.

Further, in the case of a glass substrate to be used for an application wherein a transparent conductive oxide film is to be formed thereon, like a glass substrate to be used for a liquid crystal display or a photoelectric conversion element such as a solar cell, or in the case of a glass substrate to be used for an application wherein fine concave and convex portions are formed on the glass substrate surface and then, an antireflection film is formed on the surface, it is preferred that the glass substrate has a high light transmittance, e.g. a light transmittance of at least 80% in a wavelength region of from 350 to 800 nm.

The thickness of the substrate may be suitably selected depending upon the application. In the case of a glass substrate to be used for an application wherein a transparent conductive oxide film is to be formed thereon, like a glass substrate to be used for a liquid crystal display or a photoelectric conversion element such as a solar cell, the thickness of the glass substrate is preferably from 0.2 to 6.0 mm. Within such a range, the strength of the glass substrate is high, and the light transmittance in the above-mentioned wavelength region is high.

### <Alkali barrier layer>

As described below, the alkali barrier layer of the present invention is composed of a non-uniform mixed oxide of silicon (Si) and tin (Sn). Here, in this specification, a composite oxide of silicon (Si) and tin (Sn) or a case where an oxide other than silicon (Si) and tin (Sn) is contained partly in the alkali barrier layer, may be referred to as a mixed oxide. Here, a non-uniform mixed oxide means that when the thickness of the alkali barrier layer is represented by L (nm), the composition of the mixed oxide is changed in the thickness L. Further, in this specification, terms "layer" and "film" are used, but they mean the same.

In the present invention, there is one minimum value in the molar ratio [Sn/(Si+Sn)] of tin (Sn) to the total of silicon (Si) and tin (Sn) (hereinafter referred to as the molar ratio Sn/(Si+Sn)) in the mixed oxide constituting the alkali barrier layer, and the location of the minimum value is at a position which satisfies from 0.2 L to 0.8 L from the interface on the glass substrate side among interfaces of the alkali barrier layer in the thickness direction of the alkali barrier layer.

That is, the mixed oxide constituting the alkali barrier layer is changed in its composition, specifically in the molar ratio Sn/(Si+Sn), in the thickness direction of the alkali barrier layer, and the minimum value in the molar ratio Sn/(Si+Sn) is present in the vicinity of the center in the thickness direction of the alkali barrier layer.

Accordingly, the molar ratio Sn/(Si+Sn) becomes to have the maximum value at either one of the two sides in the thickness direction of the alkali barrier layer or at both sides. That is, the alkali barrier layer has the maximum value in the molar ratio Sn/(Si+Sn) at either one of the surface side and the glass substrate side, or at both sides.

In the alkali barrier layer, the minimum value in the molar ratio Sn/(Si+Sn) is at most 0.5 time the maximum value in the molar ratio Sn/(Si+Sn). That is, in the alkali barrier layer, the molar ratio Sn/(Si+Sn) is changed by at least twice in its thickness direction.

In the present invention, the alkali barrier layer is constructed so that the molar ratio Sn/(Si+Sn) is changed by at least twice in its thickness direction, and the minimum value in the molar ratio Sn/(Si+Sn) is present in the vicinity of the center in the thickness direction of the alkali barrier layer, whereby the alkali barrier properties are improved.

The reason why the alkali barrier properties are improved by adjusting the alkali barrier layer to have the above construction, is not clear, but it is considered that the presence of the minimum value in the molar ratio Sn/(Si+Sn) and the presence of a portion where the molar ratio Sn/(Si+Sn) increases and a portion where the molar ratio Sn/(Si+Sn) decreases, are attributable to the improvement of the alkali barrier properties.

That is, capturing of an alkali component in the oxide film takes place at oxygen bond dissociation points in the oxide. The oxygen bond dissociation points are portions having a negative electrical charge. At such portions, Na⁺ as a positive electrical charge is likely to be captured. Thus, the more the oxygen bond dissociation points, the higher the Na-capturing effect (the better the alkali barrier properties). It is considered that such oxygen bond dissociation points are likely to be formed at portions where the composition of the mixed oxide is changed, and particularly when the change rate in the composition is large, the oxygen bond dissociation points tend to increase. Here, the largest point in the change rate in the composition is the change in the ratio at before and after the location of the minimum value.

In the alkali barrier layer of the present invention, the ratio of Sn to (Si+Sn) decreases from the substrate side towards the film surface, and after the presence of the minimum value, the ratio of Sn to (Si+Sn) increases towards the film surface, whereby the oxygen bond dissociation points in the layer tend to be much increased, as compared with a homogeneous composition of SnO₂ + SiO₂ or a simple gradient layer wherein the composition is gradually changed from SiO₂ to SnO₂. Consequently, the alkali barrier properties are considered to be improved. Here, in a multilayer film having a SiO₂ film and a SnO₂ film sequentially stacked, the oxygen bond dissociation points are increased at stacking interfaces, and the more the interfaces, the higher the improvement in the alkali barrier properties. However, in order to stack multilayers, many injectors are required, such being not practical. In the present invention, by a single injector, it is possible to stack a layer having many oxygen bond dissociation points therein.

Further, as will be shown by the results of the DHB test in Examples given hereinafter, diffusion of an alkali component to a film formed on the alkali barrier layer is prevented, whereby separation at the interface between the alkali barrier layer and the film formed thereon will be prevented.

The glass substrate with an alkali barrier layer of the present invention is suitable as a glass substrate to be used for an application wherein a transparent conductive oxide film is to be formed thereon, like a glass substrate to be used for a liquid crystal display or for a photoelectric conversion element such as a solar cell, or as a glass substrate to be used for an application, wherein in order to increase the light transmittance, fine concave and convex portions are formed on the glass substrate surface and then, an antireflection film is formed on the surface.

In the glass substrate with an alkali barrier layer of the present invention, the minimum value in the molar ratio Sn/(Si+Sn) is located preferably at a position which satisfies from 0.3 L to 0.7 L, more preferably in the vicinity of a position which satisfies 0.5 L , in the thickness direction of the alkali barrier layer.

In the glass substrate with an alkali barrier layer of the present invention, the minimum value in the molar ratio Sn/(Si+Sn) is preferably at most 0.4 time, more preferably at most 0.3 time, the maximum value in the molar ratio Sn/(Si+Sn). That is, the smaller the minimum value as compared with the maximum value, the more the action as a pseudo-interface works. Further, the smaller the minimum value as compared with the maximum value, the larger the change rate in the composition of the mixed oxide, and consequently, the oxygen bond dissociation points thereby formed will be increased, whereby the alkali barrier properties will be improved.

In the glass substrate with an alkali barrier layer of the present invention, the maximum value in the molar ratio Sn/(Si+Sn) is at most 1. When the molar ratio Sn/(Si+Sn) is at most 1, only Sn is present at such a site. Thus, in the alkali barrier layer of the invention, a site which is constituted solely of an oxide of Sn (i.e. SnO₂) may be present. However, in the alkali barrier layer of the invention, it is preferred that at all sites, an oxide of Si (i.e. SiO₂) is present.

In the glass substrate with an alkali barrier layer of the present invention, the maximum value in the molar ratio Sn/(Si+Sn) is preferably at least 0.05 and at most 0.7.

As mentioned above, the minimum value in the molar ratio Sn/(Si+Sn) is at most 0.5 time the maximum value in the molar ratio Sn/(Si+Sn), and the maximum value in the molar ratio Sn/(Si+Sn) is at most 1, and therefore, the minimum value in the molar ratio Sn/(Si+Sn) is at most 0.5.

The minimum value in the molar ratio Sn/(Si+Sn) is preferably at most 0.4, more preferably at most 0.3, further preferably at most 0.2, particularly preferably at most 0.1. Here, the minimum value in the molar ratio Sn/(Si+Sn) may be 0. In a case where molar ratio Sn/(Si+Sn) is 0, only Si is present at such a site. Thus, in the alkali barrier layer of the present invention, a site which is constituted solely of an oxide of Si (i.e. SiO₂) may be present.

The mixed oxide constituting the alkali barrier layer may contain metal elements other than Si and Sn, so long as they present no adverse effect to the alkali barrier layer. However, the total content of Si and Sn is preferably at least 90%, more preferably at least 95%, further preferably at least 98%, by mol% to the metal component in the mixed oxide.

In the glass substrate with an alkali barrier layer of the present invention, the thickness of the alkali barrier layer is preferably from 2 to 50 nm. If the thickness of the alkali barrier layer is less than 2 nm, it tends to be difficult to let the above change in the above molar ratio Sn/(Sn+Si) form in the thickness direction of the alkali barrier film, and it tends to be difficult to form a continuous film, such being undesirable.

On the other hand, if the thickness of the alkali barrier layer exceeds 50 nm, the optical absorption tends to increase, such being undesirable.

The thickness of the alkali barrier layer is more preferably from 4 to 40 nm, further preferably from 5 to 35 nm.

The above-mentioned alkali barrier layer may be formed, for example, by carrying out the following procedure by means of a conveyor-type atmospheric pressure CVD apparatus.

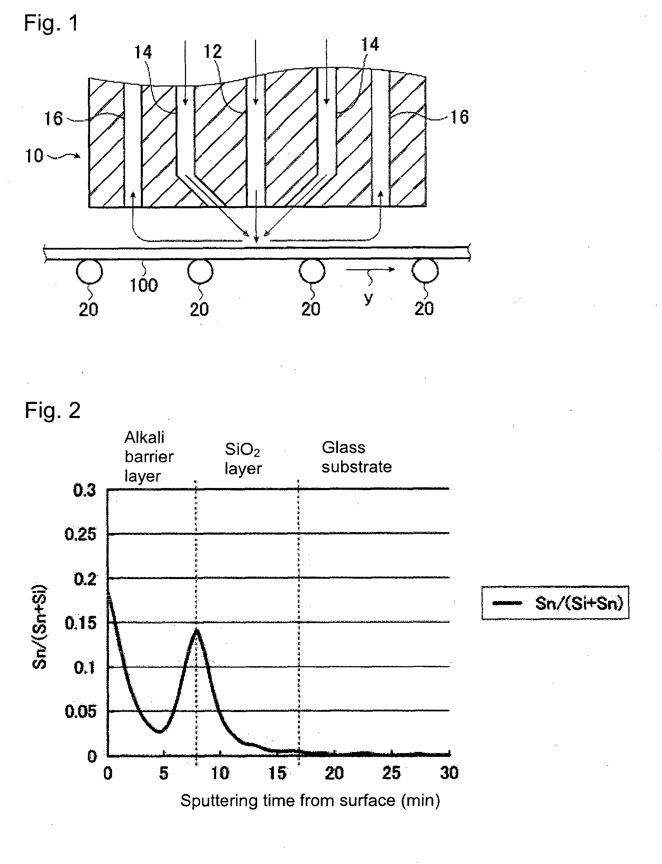

Fig. 1 is a schematic view illustrating one embodiment of a conveyor-type atmospheric pressure CVD apparatus to be used for forming the alkali barrier layer having the above-described construction. In the conveyor-type atmospheric pressure CVD apparatus shown in Fig. 1, a glass substrate 100 is transported in the direction of arrow y by a conveyor rollers 20. Above the glass substrate 100, a bidirectional flow injector 10 is disposed. This bidirectional flow injector 10 comprises a nozzle (main material nozzle) 12 for supplying the main material gas, nozzles (auxiliary material nozzles) 14, 14 for supplying an auxiliary material gas and exhaust gas nozzles 16, 16 for removal by suction of excess material gases or gases formed by a reaction. The main material gas supplied from the main material gas nozzle 11 and the auxiliary material gas supplied from the auxiliary material gas nozzles 14, 14 are mixed in a space above the glass substrate 100, as shown by arrows. Excess material gases or gasses formed by the reaction are removed by suction from the exhaust gas nozzles 16, 16, as shown by arrows.

Here, the above bidirectional flow injector in the conveyor-type atmospheric pressure CVD apparatus is meant for an injector to supply gases so that material gas flows on the transparent substrate would be in the same direction and in the opposite direction to the transportation direction of the transparent substrate.

Here, when SiH₄ as the main material gas, is supplied from the main material nozzle 12, and SnCl₄ as an auxiliary material gas and O₂ as an oxidant, are supplied from the auxiliary material nozzles 14, 14, they are mixed in a space above the glass substrate 100.

O₂ as an oxidant has a low reactivity with SnCl₄ but has a high reactivity with SiH₄, and therefore, immediately below the nozzles (i.e. the main material nozzle 12 and the auxiliary material nozzles 14), a reaction of SiH₄ + 2O₂ → Si02 + 2H₂O takes place, whereby SiO₂ will precipitate on the glass substrate. At that time, as a reaction by-product, H₂O will be formed.

H₂O formed as a reaction by-product, will be moved together with SnCl₄ as shown by arrows to the upstream side and the downstream side in the transportation direction of the glass substrate 100. Here, SnCl₄ has a low reactivity with O₂ but has a high reactivity with H₂O, and therefore, with H₂O acting as an oxidant, a reaction of SnCl₄ + 2H₂O → SnO₂ + 2HCl takes place, whereby SnO₂ will precipitate on the glass substrate.

At that time, the glass substrate 100 is transported in the direction of arrow y, whereby a mixed oxide film is formed wherein the molar ratio Sn/(Sn+Si) is changed in the thickness direction so that the molar ratio Sn/(Sn+Si) is high at the glass substrate side and the film surface side, and the molar ratio Sn/(Sn+Si) is low in the vicinity of the center in the thickness direction.

Further, as mentioned above, a mixed oxide film of Sn and Si is formed by reacting SnCl₄ with H₂O as a reaction by-product of SiH₄ and O₂. Accordingly, although the above description is made with respect to a case where SiH₄ as the main material gas, is supplied from the main material nozzle 12, and SnCl₄ as an auxiliary material gas and O₂ as an oxidant, are supplied from the auxiliary material nozzles 14, 14, the same mixed oxide film as described above may be formed by supplying SnCl₄ and O₂ from the main material nozzle 12, and supplying SiH₄ from the auxiliary material nozzles 14, 14.

In a case where the glass substrate with an alkali barrier layer of the present invention is to be used for an application wherein a transparent conductive oxide film is formed thereon, like a glass substrate to be used for a liquid crystal display or for a photoelectric conversion element such as a solar cell, a transparent conductive oxide film such as a tin oxide film will be formed on the alkali barrier layer.

Further, in such an application, in order to increase the light transmittance, there may be a case where a TiO₂ film is formed as a high refractive index layer on the glass substrate, or a case where a multilayer film having a TiO₂ film as a high refractive index layer and a SiO₂ film as a low refractive index layer sequentially stacked, is formed on the glass substrate.

Also in the glass substrate with an alkali barrier layer of the present invention, for the same purpose, between the glass substrate and the alkali barrier layer, a TiO₂ film may be formed, or a multilayer film having a TiO₂ film and a SiO₂ film sequentially stacked, may be formed. When such films are to be formed, the thickness of films is preferably from 5 to 20 nm and from 10 to 40 nm, respectively.

The transparent conductive oxide film to be formed on the alkali barrier layer of the glass substrate with an alkali barrier layer of the present invention, is preferably a tin oxide film, particularly a fluorine-doped tin oxide film. In a case where a tin oxide film is used, a fluorine-doped tin oxide film may further be formed on the tin oxide film.

In the fluorine-doped tin oxide film to be formed as a transparent conductive oxide film, the fluorine content is preferably from 0.01 to 9 mol%.

Further, in the fluorine-doped tin oxide film to be formed as a transparent conductive oxide film, the film thickness is preferably from 300 to 2,000 nm, more preferably from 450 to 1,450 nm, further preferably from 500 to 1,000 nm. In a case where a fluorine-doped tin oxide film is stacked on a tin oxide film, the thickness of the entire stacked structure is preferably from 300 to 2,000 nm, more preferably from 450 to 1,450 nm, further preferably from 500 to 1,200 nm.

Further, with respect to a glass substrate to be used for an application wherein a light transmittance is required, such as glass for automobiles, glass for displays, an optical element, a glass substrate for solar cells, glass for show-windows, optical glass, a lens for eyeglasses, etc., there may be a case where in order to increase the light transmittance, a SiO₂ film is formed as an antireflection film on the surface of the glass substrate.

Here, if the glass substrate surface before forming a SiO₂ film as an antireflection film is subjected to surface treatment with a fluorinating agent such as hydrogen fluoride or hydrofluoric acid to form fine concave and convex portions on the glass substrate surface, thereby to form a low refractive index layer on the glass substrate surface, the antireflection effect will be increased when a SiO₂ film is formed as an antireflection film.

When a SiO₂ film is formed as an antireflection film on the glass substrate surface having fine concave and convex portions formed thereon, the SiO₂ film will also have a structure having fine concave and convex portions on its surface, and such a structure will contribute to the increase in the antireflection effect. However, in a case where alkali glass is used as the glass substrate, the fine concave and convex portions on the SiO₂ film surface may be impaired by diffusion of an alkali component, whereby the antireflection effect tends to be low.

When the glass substrate with an alkali barrier layer of the present invention is used as the glass substrate for such an application, diffusion of an alkali component to the SiO₂ film as the antireflection film is prevented, whereby it is possible to maintain the antireflection effect over a long period of time. The thickness of such a SiO₂ film is preferably from 25 to 165 nm.

### EXAMPLES

Now, the present invention will be described with reference to Examples, but it should be understood that the present invention is by no means limited to such Examples.

### EXAMPLE 1

In this Example, as a glass substrate, a soda lime silicate glass substrate having a thickness of 4 mm was used.

By means of a conveyor type atmospheric pressure CVD apparatus as shown in Fig. 1, a SiO₂ film (thickness: 15 nm) as an antireflection layer was formed on the substrate 100. Here, from the main material nozzle 12 in the bidirectional flow injector 10, a SiH₄ gas diluted with nitrogen gas to a concentration of 0.36 vol% was supplied at a flow rate of 128 cm/sec. Further, from auxiliary material nozzles 14, 14, O₂ diluted with nitrogen gas to a concentration of 75.8 vol% was supplied at a flow rate of 64 cm/sec. The glass substrate 100 was transported at a rate of 6 m/min. The temperature of the glass substrate 100 during the film formation was 580°C.

Then, on the glass substrate 100 having the SiO₂ film formed thereon, an alkali barrier layer (thickness: 18 nm) composed of a mixed oxide of Si and Sn was formed by means of the conveyor type atmospheric pressure CVD apparatus as shown in Fig. 1 to obtain a glass substrate with an alkali barrier layer. Here, from the main material nozzle 12 in the bidirectional flow injector 10, a SiH₄ gas diluted with nitrogen gas to a concentration of 0.39 vol% was supplied at a flow rate of 128 cm/sec. Further, from auxiliary material nozzles 14, 14, O₂ diluted with nitrogen gas to a concentration of 0.85 vol% and SnCl₄ having a concentration of 0.47 vol% were supplied at a flow rate of 64 cm/sec. The glass substrate 100 was transported at a rate of 6 m/min. The temperature of the glass substrate 100 during the film formation was 580°C.

With respect to the glass substrate with an alkali barrier layer obtained by the above procedure, the composition profile in the thickness direction was measured by means of a scanning X-ray photoelectron spectrometer (XPS/ESCA) Quantera SXM (manufactured by Ulvak-Phi Inc.). The conditions for the measurement were as follows.

### [Conditions for measurement]

Pass Energy: 224 [eV]
Energy Step: 0.4 [eV/step]
Sputtering ions: Ar⁺
Accelerating voltage: 2 [kV]
Raster size: 3×3 [mm²]
Measurement interval: 1.5 [min.]
Sputtering rate calculated as SiO₂: 3.1 [nm/min.]

The molar ratio Sn/(Sn+Si) was calculated from the atomic composition ratio of Sn3d5 to Si2p obtained by this measurement. The results are shown in Fig. 2. In Fig. 2, the range from the film surface (in Fig. 2, the position where the sputtering time from the surface is 0 min.) to a position, where the Sn/(Sn+Si) ratio once lowers and again has a peak value, is an alkali barrier layer, and the range from this peak position to a position at which the Sn/(Sn+Si) ratio becomes to be substantially 0, is a SiO₂ layer. Further, the sputtering time from the surface shown on the abscissa may be deemed to be proportional to the distance from the surface.

As is evident from Fig. 2, in the alkali barrier layer of the present invention, one minimum value in the molar ratio Sn/(Sn+Si) is present in the vicinity of the center in the thickness direction, and the minimum value in the molar ratio Sn/(Sn+Si) was 0.14 time the maximum value in the molar ratio Sn/(Sn+Si). Further, when the thickness of the alkali barrier layer is represented by L, the position of this minimum value is located at a position corresponding to 0.37 L from the interface on the glass substrate 100 side of the alkali barrier layer, and the minimum value in the molar ratio Sn/(Sn+Si) was 0.025. Further, the maximum value in the molar ratio Sn/(Sn+Si) was 0.183. Further, in Example 1, the position of the minimum value is represented by a distance from the interface on the glass substrate side among interfaces of the alkali barrier layer, i.e. here by a distance from the interface on the SiO₂ layer side of the alkali barrier layer.

### COMPARATIVE EXAMPLE 1

In the same manner as in Example 1, a SiO₂ layer was formed on the glass substrate 100, and then, instead of forming an alkali barrier layer composed of a mixed oxide of Si and Sn, the procedure for forming a SiO₂ layer (thickness: 15 nm) by means of the conveyor type atmospheric pressure CVD apparatus was carried out again. In this regard, from the main material nozzle 12 in the bidirectional flow injector 10, a SiH₄ gas diluted with nitrogen gas to a concentration of 0.39 vol%, was supplied at a flow rate of 128 cm/sec., and from auxiliary material nozzles 14, 14, O₂ diluted with nitrogen gas to a concentration of 0.82 vol% was supplied at a flow rate of 64 cm/sec. The glass substrate 100 was transported at a rate of 6 m/min. The temperature of the glass substrate 100 during the film formation was 580°C.

Further, on the alkali barrier layer of the glass substrate with an alkali barrier layer in Example 1 obtained by the above-described procedure, and on the SiO₂ layer of the glass substrate with a SiO₂ layer in Comparative Example 1 obtained by the above-described procedure, a Ga-doped ZnO (GZO) film (thickness: 100 nm) was formed, respectively, by means of a sputtering method under the following conditions.

### [Film forming conditions]

Target area: 127 mm × 558.8 mm
Pressure: 3.0 E - 3 Torr
Power: DC 1.0 kW
Gas (flow rate): Ar 100 sccm
Transportation rate: 150 mm/min.
Temperature: Set at 140°C

After forming the GZO films, annealing was carried out at 550°C for 30 min., and then, SIMS analyses were carried out under the following conditions to relatively compare the four point average values of 23Na/64Zn in the GZO films.

### [Conditions for measurement by SIMS]

Apparatus for measurement: ADEPT1010, manufactured by Ulvak-Phi Inc.
Primary ions: O₂⁺
Accelerating voltage: 2 [kV]
Beam current: 150 [nA]
Raster size: 400×400 [µm²]
Sample angle: 45 [°]

The results are shown in the following Table.

**TABLE 1**

| | Na/Zn |
|---|---|
| Example 1 | 0.18 |
| Comparative Example 1 | 0.82 |

From the comparison of these results, it has been confirmed that while the SiO₂ layer in Comparative Example 1 has heretofore been used as an alkali barrier film, the alkali barrier layer in Example 1 composed of a mixed oxide of Si and Sn is less in an amount of transfer of Na to the GZO film and is excellent in the alkali barrier properties as compared with Comparative Example 1.

In the alkali barrier layer in Example 1, the ratio of Sn to (Si+Sn) decreases from the substrate side towards the film surface, and after the presence of the minimum value, the ratio of Sn to (Si+Sn) increases towards the film surface, whereby the oxygen bond dissociation points in the layer becomes much more as compared with Comparative Example 1 wherein the composition is not changed, and as compared with a uniform composition of SnO₂ + SnO₂, or a simple gradient layer wherein the composition is gradually changed from SiO₂ to SnO₂. It is considered that consequently, the alkali barrier properties have been improved.

### EXAMPLE 2

In this Example, as a glass substrate, a soda lime silicate glass substrate having a thickness of 3.9 mm was used.

By means of the conveyor type atmospheric pressure CVD apparatus as shown in Fig. 1, the substrate 100 was subjected to surface treatment with a fluorinating agent (HF gas) to form fine concave and convex portions on the surface of the glass substrate 100. Here, from the main material nozzle 12 in the bidirectional flow injector 10, a HF gas diluted with nitrogen gas to a concentration of 40 vol% and heated to 100°C, was supplied at a flow rate of 9.5 cm/sec. Further, from auxiliary material nozzles 14, 14, nitrogen gas heated to 150°C was supplied at a flow rate of 4.7 cm/sec. For the measurements of the temperatures and flow rates of the gases, a hot-wire anemometer (Climomaster 6543, manufactured by Kanomax Japan Inc.) was used.

After forming fine concave and convex portions on a glass substrate of the same type under the same conditions, the configuration of the concave and convex portions was measured by means of a scanning probe microscope (Model No. SPI 3800N, manufactured by SII Nanotechnology) and found to be as follows. At the concave and convex portions, the surface roughness (Ra) as stipulated in JIS B-0601 (1994) was at least 2 nm and at most 100 nm, and the maximum difference in height P-V was at least 35 nm and at most 400 nm.

Then, on the glass substrate 100 having the surface treated with the HF gas, an alkali barrier layer (thickness: 15 nm) composed of a mixed oxide of Si and Sn was formed by means of the conveyor type atmospheric pressure CVD apparatus as shown in Fig. 1. Here, from the main material nozzle 12 in the bidirectional flow injector 10, a SiH₄ gas diluted with nitrogen gas to a concentration of 0.24 vol% was supplied at a flow rate of 71 cm/sec. Further, from auxiliary material nozzles 14, 14, O₂ diluted with nitrogen gas to a concentration of 89.65 vol% and SnCl₄ having a concentration of 0.20 vol% were supplied at a flow rate of 36 cm/sec.

Then, in order to improve the antireflection, a SiO₂ film (thickness: 15 nm) was formed on the alkali barrier layer by means of the conveyor type atmospheric pressure CVD apparatus as shown in Fig. 1. Here, from the main material nozzle 12 in the bidirectional flow injector 10, a SiH₄ gas diluted with nitrogen gas to a concentration of 0.18 vol% was supplied at a flow rate of 95 cm/sec. Further, from auxiliary material nozzles 14, 14, O₂ diluted with nitrogen gas to a concentration of 73.33 vol% was supplied at a flow rate of 47 cm/sec.

In order to investigate the composition profile in the thickness direction of the alkali barrier layer in Example 2, a glass substrate with an alkali barrier layer was prepared by forming a SiO₂ film under the same conditions as in Example 1 on a flat soda lime silicate glass substrate not subjected to surface treatment with a fluorinating agent (HF gas) and having a thickness of 3.9 mm, and then, stacking an alkali barrier layer under the same conditions as in Example 2 on the SiO₂ film. With respect to this glass substrate with an alkali barrier layer, the composition profile in the thickness direction was measured by means of a scanning X-ray photoelectron spectrometer (XPS/ESCA) 1500 (manufactured by Ulvak-Phi Inc.). The conditions for the measurement were as follows.

### [Conditions for measurement]

Pass Energy: 188 [eV]
Energy Step: 0.4 [eV/step]
Sputtering ions: Ar⁺
Accelerating voltage: 1 [kV]
Raster size: 2×2 [mm²]
Measurement interval: 0.25 [min.]
Sputtering rate calculated as SiO₂: 1.7 [nm/min.]

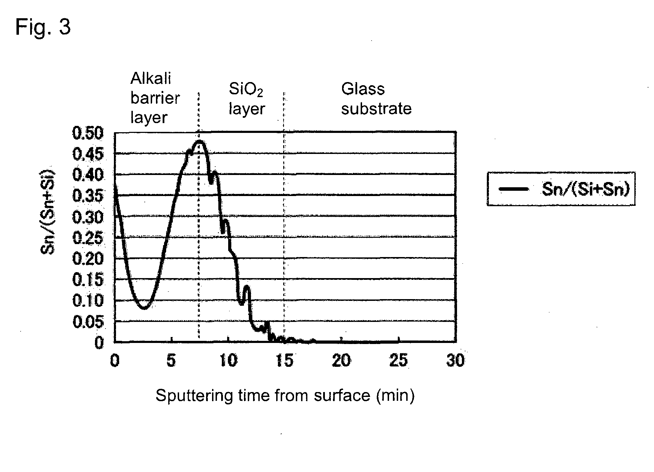

The molar ratio Sn/(Sn+Si) was calculated from the atomic composition ratio of Sn3d5 to Si2p obtained by this measurement. The results are shown in Fig. 3. In Fig. 3, the range from the film surface (in Fig. 3, the position where the sputtering time from the surface is 0 min.) to a position, where the Sn/(Sn+Si) ratio once lowers and again has a peak value, is an alkali barrier layer, and the range from this peak position to a position at which the Sn/(Sn+Si) ratio becomes to be substantially 0, is a SiO₂ layer. Further, the sputtering time from the surface shown on the abscissa may be deemed to be proportional to the distance from the surface.

As is evident from Fig. 3, in the alkali barrier layer of the present invention, one minimum value in the molar ratio Sn/(Sn+Si) is present in the vicinity of the center in the thickness direction, and the minimum value in the molar ratio Sn/(Sn+Si) was 0.17 time the maximum value in the molar ratio Sn/(Sn+Si). Further, when the thickness of the alkali barrier layer is represented by L, the position of the minimum value is located at a position corresponding to 0.67 L from the interface on the glass substrate 100 side of the alkali barrier layer, and the minimum value in the molar ratio Sn/(Sn+Si) was 0.08. Further, the maximum value in the molar ratio Sn/(Sn+Si) was 0.47.

### COMPARATIVE EXAMPLE 2

In the process in Example 2, a SiO₂ layer (thickness: 15 nm) was formed on the glass substrate 100, instead of forming an alkali barrier layer composed of a mixed oxide of Si and Sn. From the main material nozzle 12 in the bidirectional flow injector 10, a SiH₄ gas diluted with nitrogen gas to a concentration of 0.24 vol%, was supplied at a low rate of 71 cm/sec., and from auxiliary material nozzles 14, 14, O₂ diluted with nitrogen gas to a concentration of 88.89 vol% was supplied at a flow rate of 36 cm/sec.

Then, a SiO₂ film (thickness: 15 nm) was formed in the same manner as in Example 2.

With respect to Example 2 and Comparative Example 2, a pressure cooker test (hereinafter referred to as P.C.T.) was carried out, and the light transmittance was measured before and after carrying out P.C.T.

### <Method for measurement of transmittance>

### Apparatus for measurement: Spectrophotometer UV-3100PC, manufactured by Shimadzu Corporation

Method for measurement: By letting light enter from the surface on which the SiO₂ film was formed, the transmittance was measured as an integrating sphere transmittance, and was obtained as an average value within a wavelength range of from 400 to 700 nm.

### <Pressure cooker test method>

Apparatus used: Pressure cooker test apparatus (HAST CHAMBER) EHS-221 (M), manufactured by Espec Corp

### [Test conditions]

Temperature: 138°C
Relative humidity: 85 RH%
Pressure: 0.27 MPa
Testing time: 9 hr
Ultrasonic cleaning after test: By means of a ultrasonic cleaner manufactured by TAKEDA, the test sample was immersed in distilled water and cleaned for 5 min.

The results are shown in the following Table.

**TABLE 2**

| | Transmittance (%) with wavelength of from 400 to 700 nm | | |
|---|---|---|---|
| | Before P.C.T. | After P.C.T. | Difference in transmittance |
| Example 2 | 94.02 | 93.01 | -1.01 |
| Comparative Example 2 | 94.34 | 91.72 | -2.62 |

From the comparison of these results, it has been confirmed that in Example 2, the decrease in the light transmittance after carrying out P.C.T. is less than in Comparative Example 2.

The reason for the decrease in the light transmittance by carrying out P.C.T. is considered to be such that from the soda lime silicate glass, Na precipitated in the vicinity of the film surface will be reacted with H₂O in the atmosphere to form NaOH, and by this NaOH, the SiO₂ film will be eroded, whereby the fine concave and convex portions on the surface will be impaired.

In the alkali barrier layer composed of the mixed oxide of Si and Sn in Example 2, the ratio of Sn to (Si+Sn) decreases from the substrate side towards the film surface, and after the presence of the minimum value, the ratio of Sn to (Si+Sn) increases towards the film surface, whereby the oxygen bond dissociation points in the layer becomes very many. In Example 2 wherein the oxygen bond dissociation points in the layer are very many, the alkali barrier layer was confirmed to be excellent as compared with the layer in Comparative Example 2 wherein the composition is not changed.

### EXAMPLE 3 and COMPARATIVE EXAMPLE 3

On the glass substrate with an alkali barrier layer prepared in Example 1 and on the glass substrate with a SiO₂ layer prepared in Comparative Example 1, respectively, by means of the conveyor type atmospheric pressure CVD apparatus as shown in Fig. 1, a SnO₂ film (thickness: 275 nm) and, on the SnO₂ film, a fluorine-containing SnO₂ film (thickness: 275 nm) were formed in this order.

Here, from the main material nozzle 12 in the bidirectional flow injector 10, SnCl₄ diluted with nitrogen gas to a concentration of 1.20 vol% was supplied at a flow rate of 75 cm/sec. Further, from auxiliary material nozzles 14, 14, H₂O diluted with nitrogen gas to a concentration of 46.22 vol% was supplied at a flow rate of 37.5 cm/sec, to form the SnO₂ film.

Then, from the main material nozzle 12 in the bidirectional flow injector 10, SnCl₄ diluted with nitrogen gas to a concentration of 1.20 vol% and HF having a concentration of 0.36 vol% were supplied at a flow rate of 75 cm/sec. Further, from auxiliary material nozzles 14, 14, H₂O diluted with nitrogen gas to a concentration of 46.22 vol% was supplied at a flow rate of 37.5 cm/sec, to form the fluorine-containing SnO₂ film.

Here, during the formation of the SnO₂ film and the fluorine-containing SnO₂ film, the transportation rate of the glass substrate 100 was 3.2 m/min., and the temperature of the glass substrate 100 was 575°C.

With respect to the substrates obtained in Example 3 and Comparative Example 3, a DHB test was carried out by the following procedure.

### <DHB test method>

A layer separation risk was measured by a dump heat bias (DHB) type durability test. This test is one to simultaneously evaluate electrical and thermal attacks on a test piece coated with a thin film. A glass test piece having a film formed thereon was heated for a sufficient time to bring the temperature to be constant and at the same time, subjected to an electric field.
(1) The test piece was placed between two electrodes. The surface having no film formed thereon was contacted to a graphite electrode (anode), and a copper electrode covered with aluminum (cathode) was placed on the film-formed surface of the test piece. Parameters were set as follows. After heated to a testing temperature, the test piece was held at a voltage of 200 V for a voltage-application time of 15 min.
(2) After cooled to room temperature, the film-formed side of the test piece is exposed to an atmosphere with a relative humidity of 100% to let agglomeration take place on the film-formed side (at an agglomeration humidity, a water temperature of 55°C, and a vaporization temperature of 50°C±2°C). Thereafter, the presence or absence of film separation at the film surface of the test piece is confirmed.

Using another test piece prepared under the same conditions, this cycle is repeated while gradually raising the temperature, whereby a temperature at which the film-formed surface of the test piece is separated, is taken as Tₘₐₓ (°C), and the higher the Tₘₐₓ, the higher the durability.

The results are shown in the following Table. Further, in Example 3 and Comparative Example 3, separation took place at the interface between the fluorine-containing SnO₂ film and its underlayer. The underlayer is meant for the alkali barrier layer in Example 3 and the SiO₂ film in Comparative Example 3.

**TABLE 3**

| | Tₘₐₓ (°C) |
|---|---|
| Example 3 | 135 |
| Comparative Example 3 | 105 |

From the comparison of these results, it has been confirmed that in Example 3, Tₘₐₓ is high, and the durability is high as compared with in Comparative Example 3.

The mechanism for film separation at the time of carrying out the DHB test is considered to be as follows.

### <Mechanism for film separation>

The mechanism for occurrence of separation at the interface between the SiO₂ film and the SnO₂ film, is disclosed in detail in a known literature (e.g. Thin Solid Films 423 (2003) 153-160) and is considered to be such that by a voltage applied between the glass side as a positive pole and the SnO₂ side as a negative pole, Na⁺ contained in soda lime silicate glass is moved to the interface between the underlayer and the SnO₂ film, as shown below.
1. Na⁺ + e- → Na
2. H₂O + Na → NaOH + 1/2H₂
3. 2H₂ + SnO₂ → Sn + 2H₂O

The above reactions take place at the interface between the SiO₂ film and the SnO₂ film, whereby a Sn-O bond between Sn in the fluorine-containing SnO₂ film and the oxygen (O) in the underlayer, is broken to lead to the interface separation.

In Example 3, Tₘₐₓ is high, whereby it has been confirmed that the alkali barrier layer of Example 3 composed of the mixed oxide of Si and Sn, is superior as compared with Comparative Example 3. The reason for this superiority is considered to be such that as compared with Comparative Example 3, the oxygen bond dissociation points in the layer are much more in Example 3.

### INDUSTRIAL APPLICABILITY

The glass substrate with an alkali barrier layer of the present invention is improved in the alkali barrier properties and thus is useful as a glass substrate to be used for preparation of a liquid crystal display or a photoelectric conversion element such as a solar cell.

The entire disclosure of Japanese Patent Application No. 2011-192511 filed on September 5, 2011 including specification, claims, drawings and summary is incorporated herein by reference in its entirety.

### REFERENCE SYMBOLS

10: Bidirectional flow injector
12: Main material nozzle
14: Auxiliary material nozzle
16: Exhaust gas nozzle
20: Conveyor roller
100: Glass substrate

## Claims

1. A glass substrate with an alkali barrier layer, comprising a glass substrate and an alkali barrier layer formed thereon, wherein
the alkali barrier layer is composed of a mixed oxide of silicon (Si) and tin (Sn), and when the thickness of the alkali barrier layer is represented by L (nm), the ratio between silicon (Si) and tin (Sn) in the mixed oxide is changed in the thickness direction so that the minimum value in the molar ratio [Sn/(Si+Sn)] of tin (Sn) to the total of silicon (Si) and tin (Sn) in the mixed oxide is located at a position which satisfies from 0.2 L to 0.8 L from the interface on the glass substrate side among interfaces of the alkali barrier layer in the thickness direction of the alkali barrier layer, and
the minimum value is at most 0.5 time the maximum value in the molar ratio.

2. The glass substrate with an alkali barrier layer according to Claim 1, wherein the minimum value is at most 0.1.

3. The glass substrate with an alkali barrier layer according to Claim 1 or 2, wherein the maximum value is at least 0.05 and at most 0.7.

4. The glass substrate with an alkali barrier layer according to any one of Claims 1 to 3, wherein the thickness of the alkali barrier layer is from 2 to 50 nm.

5. The glass substrate with an alkali barrier layer according to any one of Claims 1 to 4, wherein the glass substrate is made of alkali glass containing an alkali metal oxide.

6. The glass substrate with an alkali barrier layer according to any one of Claims 1 to 5, wherein a TiO₂ layer, or a multi-layer film having a TiO₂ layer and a SiO₂ layer stacked, is formed between the glass substrate and the alkali barrier layer.

7. The glass substrate with an alkali barrier layer according to any one of Claims 1 to 6, wherein fine concave and convex portions are formed on the surface of the glass substrate on which the alkali barrier layer is formed.

8. The glass substrate with an alkali barrier layer according to any one of Claims 1 to 7, wherein a SiO₂ layer is formed between the glass substrate and the alkali barrier layer, or on the surface of the alkali barrier layer.

9. A glass substrate with a transparent conductive oxide film, comprising the glass substrate with an alkali barrier layer as defined in any one of Claims 1 to 8, and a fluorine-doped tin oxide film formed as a transparent conductive oxide film on the alkali barrier layer.

10. A glass substrate with a transparent conductive oxide film, comprising the glass substrate with an alkali barrier layer as defined in any one of Claims 1 to 8, and a tin oxide film and a fluorine-doped tin oxide film stacked as transparent conductive oxide films on the alkali barrier layer.
